Europäisches Patentamt

European Patent Office ·

Office européen des brevets

(19)

(11) Publication number: **0 404 381**

**A2**

## (12) EUROPEAN PATENT APPLICATION

(21) Application number: **90306093.7**

(22) Date of filing: **05.06.90**

(51) Int. Cl.5: **G09B 9/05**

(30) Priority: **19.06.89 US 368000**

(43) Date of publication of application:
**27.12.90 Bulletin 90/52**

(84) Designated Contracting States:
**DE FR GB IT SE**

(71) Applicant: **EVANS & SUTHERLAND COMPUTER CORPORATION**
**580 Arapeen Drive**
**Salt Lake City Utah 84108(US)**

(72) Inventor: **Briggs, John Arthur**
**2345 Logan Circle**
**Salt Lake City, Utah 84108(US)**
Inventor: **Deyo, Roderic Carleton**
**2474 Emerson Avenue**
**Salt Lake City, Utah 84108(US)**
Inventor: **Haug, Edward Joseph**
**1407 Eastview Drive**
**Coralville, Iowa 52241(US)**

(74) Representative: **Coles, Graham Frederick**
**Sommerville & Rushton et al**
**11 Holywell Hill**
**St Albans Hertfordshire AL1 1EZ(GB)**

(54) Real-time vehicle simulation.

(57) An automobile-simulation graphics display D is generated in sequential frames (1-7) in dependence upon positions and movements of driver controls 12, 14, 16, 18, signalled by transducers 22. Non-linear suspension and chassis models 26 and 28 operate in conjunction with a road model 34, to derive from the transducer outputs, representation of a current vehicle-position (including orientation). A prediction of vehicle-position five display-frames in the future is made from this representation by a chassis prediction model 36 using drive-train and steering and control extrapolations derived by units 30 and 32 from the transducer outputs. The five-frame lead compensates for delay in computing, processing data for generation of the image display, and display of the image (54, 56, 58).

FIG. 1

## Real-Time Vehicle Simulation

This invention relates to methods and systems of the kind for providing a display simulating a vehicle in real time in accordance with signals derived in dependence upon vehicle-control actions of a driver or other operator.

Simulation methods and systems of the kind specified above are known in which a driver or other operator manipulates conventional controls to be shown the results of those actions through a simulation of vehicle-response. Simulators are widely used, for example, in training pilots and others in relation to airplanes, helicopters and ground vehicles, and in test and design work.

In the current state of technology, a visual display is considered a necessary component of a vehicle simulator, so that as the operator manipulates the controls of the simulation vehicle, he/she is provided with a view simulating what would be seen in reality, as the vehicle moves in a programmed environment. Positional signals are developed to indicate the position and orientation of the vehicle in the relevant environment, and representative simulator data is then supplied to a computer graphics system to attain a dynamic display.

The operation of the computer graphics system to provide image display signals from the simulator data, involves a time delay that can commonly present a problem. For example, a high performance automobile may respond to the controls with a delay of only thirty milliseconds (30 ms). Whereas simulator models for such an automobile are capable of approaching such response times in providing simulator electrical signals to indicate the position and orientation of the car, the utilization of such simulator signals by a computer graphics system (image generator) to provide signals for a visual display, is likely to take much longer, e.g. sixty milliseconds (60 ms). Thus, accepting the inherent delay of the graphics system introduces a response delay that is intolerable for many simulator applications.

Techniques have been used in previous vehicle simulators to compensate for the delay of the graphics system or image generator. Generally, compensation has involved extrapolating from the current motion of the vehicle to predict future positional data for the display. Specifically, polynomial extrapolation, as well as feedback techniques and moving average techniques, have been proposed for compensating time delays in prior systems. However, such arrangements tend to be inaccurate and typically impose the limitation that linear dynamics models be employed in the system. Because vehicle dynamics are not linear, a severe constraint may be imposed on model fidelity if operation is restricted to motion extrapolation or linear prediction. Accordingly, a need exists for an improved vehicle-simulation method and system that is relatively economical, enables the use of non-linearity in models, and enables realistic time approximation of the motion characteristics of an actual vehicle, to be realised.

It is an object of the present to provide a simulation method and system of the said kind specified above, by which the above need can be met to a substantial extent.

According to one aspect of the present invention a simulation method of the said kind, is characterised in that signals representative of vehicle position are derived from the first-mentioned signals, that predicted-position signals in accordance with successive predictions of position of the vehicle at a predetermined later time are derived in accordance with the position-representative signals, and that the simulation display is provided in dependence upon the predicted-position signals.

The time lead in the predicted-position signals may be such as to compensate substantially for delay in the provision of the display from those signals.

According to another aspect of the present invention a system for use by a driver to simulate a vehicle in real time, comprises:
control means actuable to provide control signals representative of control actions for the simulated vehicle;
vehicle simulation model means coupled to receive said control signals and responsive to provide representative positional signals indicative of the positional state of the simulated vehicle;
vehicle prediction model means coupled to receive said control signals and said representative positional signals, said vehicle prediction model means for predicting from said representative positional signals based on said control signals to provide predicted positional signals indicative of a future positional state of the simulated vehicle; and
reaction display means responsive to said predicted positional signals for manifesting a positional state of said vehicle to said driver and involving a substantial delay whereby said future positional state is approximated.

The vehicle simulation model means may incorporate non-linear operating elements, and may comprise a suspension model unit and a chassis model unit, either or both of which may be non-linear units. Additionally or alternatively, the vehicle simulation model means may include a road model for simulating operating conditions for the vehicle.

The reaction display means may comprise a display system for manifesting a positional state of said vehicle as a visual scene. The vehicle prediction model may provide future positional signals advanced in time to approximate the time delay of such display system. A graphics display apparatus may be involved, and may comprise a sequential frame display unit to provide a dynamic display. The vehicle prediction model means may in these circumstances provide predicted positional signals at least four sequential display frames in advance of said position signals.

A simulation method and system in accordance with the present invention will now be described, by way of example, with reference to the accompanying drawings, in which:

FIGURE 1 is a block and pictorial diagram of the system; and

FIGURE 2 is a timing diagram illustrating the operation of the system of FIGURE 1.

In general, the method and system to be described involve simultaneous separate, but coordinated, dynamics models, each performing a specialized function in real time. Non-linearity is built into the models as needed. At least one model simulates the complete vehicle movement to provide reference positional signals indicative of current position and orientation. A prediction model utilizes the positional reference signals from the simulation model along with extrapolation representations (solely from control actions) to predict the positional state of the vehicle at a time approximating the time of display. Model fidelity is ensured by periodically updating predictions with initial reference conditions provided from a full chassis simulation model. The simulation model involves two separate units, one in the form of a non-linear suspension unit with relatively large bandwidth for full road and handling inputs. The other unit is a non-linear full vehicle dynamics model with some or all of the non-linear effects simulated.

The method and system are described below in detail, but it is to be understood that the models, extrapolation techniques, image generators, display units, and other elements used in the described method and system, may be embodied in a wide variety of different forms, some of which may be quite different from those of the disclosed embodiment.

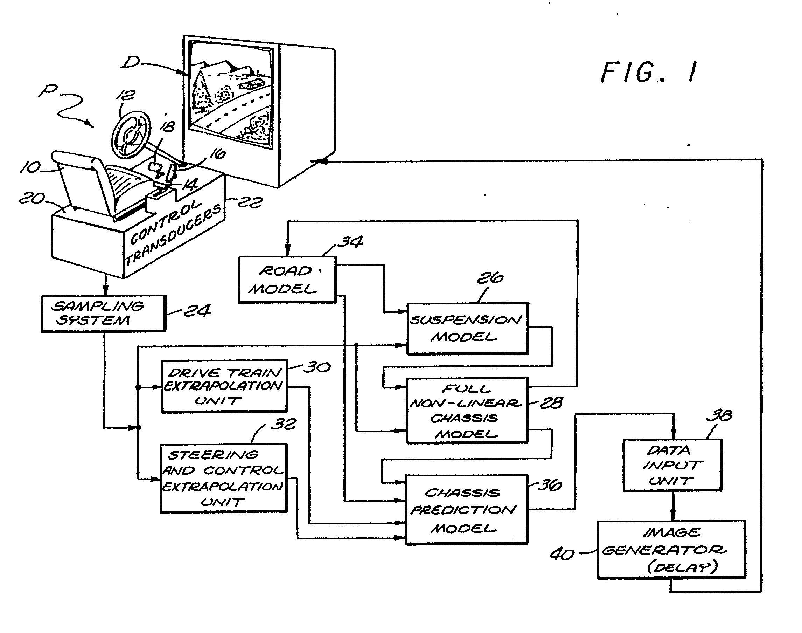

Referring initially to FIGURE 1, a driver position P (upper left) is generally represented to embody the conventional controls of an automobile. In accordance with the operation of the system of FIGURE 1, a driver at the position P operates the controls, as though driving a car. As a result, the driver is presented with a real-time display D reflecting his actions in a programmed environment in which the response of the display D to control actions by the driver is realistic and timely. In accordance with well known techniques, other effects such as motion may also be simulated for the driver.

Considering the system in somewhat greater detail, the driver position P incorporates a seat 10 that faces typical automobile controls which are illustrated specifically as a steering wheel 12, a gear or shift lever 14, an accelerator pedal 16 and a brake pedal 18. The controls are illustrated mounted on a platform 20 of a housing or block that incorporates control transducers 22. The control transducers 22 may take the form of various well-known instrumentation devices to provide analog signals continuously indicating the positions and movements of the controls.

The continuous analog signals from the control transducers 22 are periodically sampled by a sampling system 24 which also converts representative signal values to a digital format in accordance with well-known techniques. Thus, periodic digital control signals are provided to indicate the driver's control actions at the position P. Categorically, the digital control signals from the sampling system 24 relate either to steering manoeuvres or drive-train operations.

The digitized control signals from the sampling system 24 are supplied to a suspension model 26 and a full non-linear chassis model 28, and also to extrapolation units 30 and 32. The model 28 is connected with a road model 34 that, together with the model 28 and the extrapolation units 30 and 32, is connected to a chassis prediction model 36. Generally, the models 26, 28, 34 and 36 are responsive devices to represent conditions that result from input signals indicating dynamic operation. Various forms of such devices are well known in the science of simulation.

The suspension model 26 is a high frequency apparatus utilizing computer techniques as well known in the art and implements a set of non-linear recursive suspension and time equations to model accurately a wide spectrum of vehicle-suspension motion. It receives signals from the road model 34, and in that regard uses a full road geometry to input tire forces.

The model 26 runs faster than the full non-linear model 28, and accordingly, allows for shorter integration time steps. Such operation improves the model bandwidth and integration stability and accuracy. In that regard, higher frequency motion (above 10 hertz) can be modelled.

The output from the suspension model 26 is in the form of positional and velocity data and is supplied to the full non-linear chassis model 28 which makes use of the full recursive vehicle dynamics algorithms and calculates highly accurate positional information on the chassis (position and orientation). The model 28 makes use of signalled drive-train forces and the results of calculations of high-frequency suspension motions carried out in the suspension model 26. In this regard, the full chassis model 28 provides accurate initial conditions to the non-linear chassis prediction model 36 for the computation of data for each frame of a dynamic picture shown by the display D.

The chassis prediction model 36 is a relatively simple yet accurate device, used to perform chassis motion integration advanced by several frame cycles. The model 36 processes extrapolation information from the drive-train extrapolation unit 30 and the steering and control extrapolation unit 32. Accordingly, the prediction model 36 receives: initial condition data (from model 28); extrapolated driver inputs (from the units 30 and 32); driver inputs (through the models 28 and 34 from the sampling system 24); and full road geometry (from the road model 34). The extrapolation units 30 and 32 simply extrapolate driver control data to provide predicted future data, utilizing well-known extrapolation techniques.

In operation, the prediction model 36 is updated with a new set of initial conditions from the full chassis model 28 every frame cycle. Then, using road data and extrapolated control data, the prediction model provides positional signals indicative of chassis position and orientation, as predicted to exist five frames hence in the picture of the display D.

Signals representative of the predicted positional information from the model 36 are provided to a data input unit 38 which is in turn connected to a computer graphics system or image generator 40. The image generator drives the display D.

As explained above, the image generator 40 is a relatively slow structure and accounts for the primary time delay in the operation of the total system. For example, in one implementation of the disclosed embodiment, the image generator involves a time loss approximating a delay of forty-seven milliseconds (47 ms), or four display-frames at eighty-five hertz (85 Hz). The delay is accounted for in a considerable volume of signal processing and computation to provide the video signals for driving the dynamic picture of the display D.

To consider the overall system operation somewhat summarily, control actions by the driver at the position P result in control signals that are used by the suspension model 26 and the full non-linear chassis model 28 in conjunction with signals from the road model 34, to develop status signals indicative of the current positional state of the simulated vehicle (position and orientation). The status signals are supplied to the chassis prediction model 36 along with extrapolated prediction signals from the units 30 and 32 and signals from the road model 34.

The extrapolation signals supplied to the prediction model 36 are essentially rate-of-change indications developed by the extrapolation units 30 and 32. The drive-train extrapolation unit 30 supplies predicted control signals indicating a predicted drive-train state for the future, whereas the steering and control extrapolation unit 32 supplies corresponding prediction signals related to the steering and control operation. The extrapolated prediction signals from the units 30 and 32, may for example, reflect conditions as predicted to exist five display frames hence in the operation of the total simulator.

The extrapolation positional data from the units 30 and 32 is utilized by the model 36 along with the current positional data from the model 28 and data from the road model 36, to develop predicted positional information (signals representative of vehicle position and orientation). Thus, the developed positional information actually represents the predicted position and orientation of the vehicle at a time several display frames ahead of the instant state of the vehicle.

Where, as suggested above, the predicted positional signals lead the current state of the vehicle by five picture frames of the display D, they will be some sixty milliseconds (60 ms) in advance of the current state. Thus, if the data input unit 38 and the image generator 40 collectively involve a delay of approximately sixty milliseconds (60 ms), the signals provided to the display D will be timely. The delays incurred by the models, e.g. models 26 and 28, in essence reflect the inherent delay of the vehicle, Thus, by utilizing display input signals which lead the instant positional data by an interval that is substantially the same as the delay incurred in image generation (in particular within the image generator 40) enables a timely delay by the display D to be achieved. It is noteworthy in this respect that the predicted display data is computed freshly for each frame and is based on extrapolated input signals sensed from the driver's control motions and the current positional information as provided from the model 28.

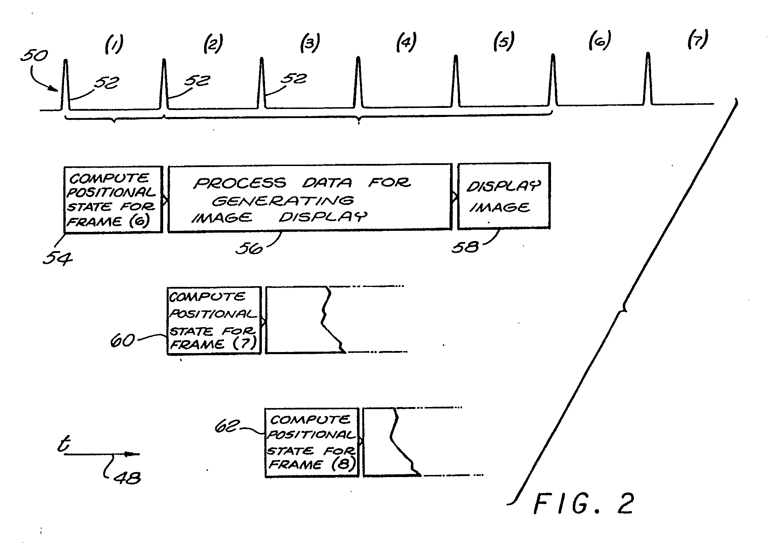

The operation will now be further explained with reference to the timing diagram of FIGURE 2.

FIGURE 2 is a plot of simulator events with regard to time t moving horizontally from left to right as indicated by an arrow 48 (lower left) . A waveform 50 (top left) defines spaced spikes 52, each of which indicates the beginning of a display frame. In that regard, the display D (FIGURE 1) may incorporate a cathode-ray tube (CRT) device driven in a raster scan pattern to compose a colour display or image from a multitude of individual picture elements or pixels. Individual pixel representations are computed by the image generator 40 (FIGURE 1), in terms of colour and intensity.

Image generators in various forms are well known in the prior art and have been widely used in simulation systems. Details of various image generators are disclosed in the textbooks: "Principles of Interactive Computer Graphics", Second Edition, by William M. Newman and Robert F. Sproull, McGraw-Hill Book Company, 1979; and "Fundamentals of Interactive Computer Graphics", by J. D. Foley and A. Van Dam, Addison-Wesley Publishing Company, 1984.

In accordance with the conventional operation of CRT displays, each scanning or tracing of the full-screen image constitutes a single frame. In an implementation hereof, frames are repeated in a cycle of approximately twelve milliseconds (12 ms) as depicted by the spaced-apart spikes 52 in FIGURE 2. For convenience, the spaces between the spikes 52 are designated in sequence as (1), (2), (3), (4) and so on, indicating display frame intervals.

As will be apparent from FIGURE 2, the time for computing the positional state for each frame can substantially coincide with the interval of a frame, e.g. intervals (1), (2), and so on. In that regard, a block 54 (left centre) represents the computing interval which essentially accommodates the development of positional signals supplied from the chassis prediction model 36 (FIGURE 1). Processing the positional signals by the image generator 40 and the data input unit 38 to produce image signals, involves a delay of approximately thirty-six milliseconds (36 ms). That interval of three frames is represented by a block 56 in FIGURE 2 embracing intervals (2), (3) and (4). The image from interval (1) is then displayed during interval (5), an operation which is represented by a block 58.

Considering the diagram of FIGURE 2 further, the positional state is computed during the interval (1) for the display of a frame during the interval (5). As a result of the delay incurred in processing the state signals into image signals (represented by block 56) and embracing intervals (2), (3) and (4), the represented data for the frame of interval (5) is ready for display at the time of interval (5). Thus, the display is timely. The display is fully rendered at the start of interval (6).

As shown by the block 60 in FIGURE 2, data is computed for the display that is to occur during interval (7), during interval (2). Similarly, a block 62 indicates computation of the data that is predicted for the display that is to occur during the next interval (not shown), namely interval (8) in the sequence. Accordingly, each display is computed based on a future predicted positional state as manifest by the driver controls, so as thereby to accomplish a timely display.

To consider the operation of the system further, assume that a terrain and road program has been installed in the road model 34 (FIGURE 1) embodying well-known techniques and practices of the prior art. Further, assume that the suspension model 26 and the non-linear chassis model 28 register current positional data for the simulated vehicle, again operating in accordance with well-known techniques of the prior art. The display D then shows the driver a view of current simulated conditions.

Now, assume the driver takes action and initiates a clockwise motion of the wheel 12. The movement is immediately indicated by signals from the sampling system 24; the sampling may be at a rate well above one hundred hertz (100 Hz). The control signal indicating a change in the steering is processed in the steering and control extrapolation unit 32 to provide a predicted rate-of-change signal which is supplied to the chassis prediction model 36. The chassis prediction model 36 proceeds from data provided by the model 28 (current positional data) to compute future positional data based on the rate-of-change signals from the unit 32. Accordingly, the chassis prediction model 36 generates signals representative of the future position and orientation of the vehicle as it will exist five frames hence. That is, the current state as simulated is used with extrapolated input to accomplish the chassis dynamics prediction as represented by signals from the model 36. In that regard, the model 36 may involve in addition to dynamic models well-known in the prior art, adaptive optimal filtering techniques, also well-known in the prior art, using recursive Kalman filters. In addition to steering-wheel position, the model 36 also, of course, deals with velocity and acceleration to generate the desired complete range of future positional signals.

Signals from the prediction model 36 are supplied through the data input unit 38 to the image generator 40 for processing into image scan signals. As discussed above, the total processing requires an interval of five frames with the consequence that the signal-represented display data emerges from the image generator 40 to drive the display D in a timely fashion. Thus, the assumed initial rotation of the wheel 12 by the driver is extrapolated to predict a display coincident with an appropriate response of the simulated vehicle.

The system as disclosed above offers the capability of following the proper wheel torques and resulting vehicle accelerations during gear-change or shifting sequences, since proper engine torques are modelled accurately by the individual models. The only extrapolation involved is the assumption that the current operation by the driver continues for a predetermined number of frames after initiation of the action by the driver.

In the disclosed embodiment, five frames are used as appropriate delay. If the assumption is incorrect, it is corrected at the start of the next frame after initiation. Consequently, the deviation, involving a single frame time, tends to be inconsequential. However, indications are that steering extrapolation and the resulting dynamically modelled vehicle motion will remain accurate over a full five-frame prediction time as long as the correct vehicle initial positions are updated every frame cycle as provided by the non-linear chassis model 28 in FIGURE 1.

The present invention compensates for the time delay in the image generator whilst simultaneously providing accurate full vehicle dynamics. The technique allows real-time, man-in-the-loop simulation to include vehicles whose performance envelopes previously exceeded the capabilities of conventional simulator systems.

It will be appreciated that the present invention may be employed in many applications and for simulation of operation of vehicles of various kinds.

## Claims

1. A method for providing a display simulating a vehicle in real time in accordance with signals derived in dependence upon vehicle-control actions of a driver or other operator, characterised in that signals representative of vehicle position are derived from the first-mentioned signals, that predicted-position signals in accordance with successive predictions of position of the vehicle at a predetermined later time are derived in accordance with the position-representative signals, and that the simulation display is provided in dependence upon the predicted-position signals.

2. A method according to Claim 1 wherein the time lead in the predicted-position signals compensates substantially for delay in the provision of the display from those signals.

3. A system for use by a driver to simulate a vehicle in real time, comprising:
control means actuable to provide control signals representative of control actions for the simulated vehicle;
vehicle simulation model means coupled to receive said control signals and responsive to provide representative positional signals indicative of the positional state of the simulated vehicle;
vehicle prediction model means coupled to receive said control signals and said representative positional signals, said vehicle prediction model means for predicting from said representative positional signals based on said control signals to provide predicted positional signals indicative of a future positional state of the simulated vehicle; and
reaction display means responsive to said predicted positional signals for manifesting a positional state of said vehicle to said driver and involving a substantial delay whereby said future positional state is approximated.

4. A system according to Claim 3 wherein said vehicle simulation model means incorporates non-linear operating elements.

5. A system according to Claim 3 or Claim 4 wherein said vehicle simulation model means comprises a suspension model unit and a chassis model unit.

6. A system according to Claim 5 wherein said vehicle suspension model unit is a non-linear unit.

7. A system according to Claim 5 or Claim 6 wherein said chassis model unit is a non-linear unit.

8. A system according to any one of Claims 3 to 7 wherein said vehicle simulation model means includes a road model for simulating operating conditions for said vehicle.

9. A system according to any one of Claims 3 to 8 wherein said reaction display means comprises a display system for manifesting a positional state of said vehicle as a visual scene.

10. A system according to claim 9 wherein said vehicle prediction model provides future positional signals advanced in time to approximate the response-time delay of said display system.

11. A system according to any one of Claims 3 to 10 wherein said reaction display means comprises a graphics display apparatus.

12. A system according to claim 11 wherein said graphics display apparatus comprises a sequential frame display unit to provide a dynamic display.

13. A system according to claim 12 wherein said vehicle prediction model means provides predicted positional signals at least four sequential display frames in advance of said position signals.

14. A system according to any one of Claims 3 to 13 wherein the vehicle simulated is an automobile.

FIG. 1

(1)    (2)    (3)    (4)    (5)    (6)    (7)

50

52    52    52

| COMPUTE POSITIONAL STATE FOR FRAME (6) | PROCESS DATA FOR GENERATING IMAGE DISPLAY | DISPLAY IMAGE |

54        56        58

| COMPUTE POSITIONAL STATE FOR FRAME (7) | |

60

| COMPUTE POSITIONAL STATE FOR FRAME (8) | |

62

t

48

*FIG. 2*

EP 0 404 381 A2